Europäisches Patentamt

**European Patent Office**

**Office européen des brevets**

(19)

(11) Veröffentlichungsnummer: **0 024 468**
**B1**

(12) **EUROPÄISCHE PATENTSCHRIFT**

(45) Veröffentlichungstag der Patentschrift:
27.07.83

(51) Int. Cl.³: **H 03 K 17/92**, H 03 K 19/195

(21) Anmeldenummer: **80101923.3**

(22) Anmeldetag: **10.04.80**

(54) Injektionsstrom-gesteuerte Schaltung mit Josephson-Elementen und deren Verwendung in logischen Schaltungsanordnungen.

(30) Priorität: **20.08.79 US 68299**

(43) Veröffentlichungstag der Anmeldung:
**11.03.81 Patentblatt 81/10**

(45) Bekanntmachung des Hinweises auf die Patenterteilung:
**27.07.83 Patentblatt 83/30**

(84) Benannte Vertragsstaaten:
**DE FR GB**

(73) Patentinhaber: **International Business Machines Corporation, Old Orchard Road, Armonk, N.Y. 10504 (US)**

(72) Erfinder: **Gheewala, Tushar Ramesh, 768 Delano Road, Yorktown Heights, N.Y. 10598 (US)**

(74) Vertreter: **Schröder, Otto, Dr. Ing., Säumerstrasse 4, CH-8803 Rüschlikon (CH)**

(56) Entgegenhaltungen:
**DE-A-2 735 133**
**DE-A-2 810 649**
**US-A-3 953 749**
**US-A-4 051 393**
**IBM TECHNICAL DISCLOSURE BULLETIN, Band 22, Nr. 7, Dezember 1979 New York T. GHEEWALA »Parallel-Connected, Current Injection or Gate for Josephson Technology« Seiten 2954 bis 2956**
**BULLETIN ASE/UCS, Band 68, Nr. 2, 22. Januar 1977 P. WOLF »Josephson-Kontakte in der Digitaltechnik« Seiten 66 bis 70**
**RADIO FERNSEHEN ELEKTRONIK, Band 24, Nr. 17, 1975 W. D. SCHMIDT »Kyroelektronische Bauelemente für die Digitaltechnik« Seiten 549 bis 552**

## Injektionsstrom-gesteuerte Schaltung mit Josephson-Elementen und deren Verwendung in logischen Schaltungsanordnungen

Die Erfindung bezieht sich auf Schaltungen mit Josephson-Elementen, bei denen die Schaltvorgänge durch injizierte Ströme gesteuert werden. Darüberhinaus werden Verwendungsmöglichkeiten solcher Schaltungen in logischen Schaltungsanordnungen beschrieben.

Schaltungen, die Josephson-Elemente oder -kontakte aufweisen, sind, vor allem für Anwendungen in Datenverarbeitungsanlagen, in großer Zahl bekannt geworden. So wurden z. B. in den US-Patenten 4 051 393 und 4 117 354 und in einem in den Applied Physics Letters vom 15. Oktober 1978, Seite 781 ff., erschienenen Artikel »Josephson Logic Circuit Based on Nonlinear Current Injection in Interferometer Devices« logische Schaltungen beschrieben, in denen Josephson Interferometer entweder durch direkte Strominjektion oder durch elektromagnetische Einkopplung von über den Josephson-Elementen angeordneten Leitungen zugeführten Steuerströmen geschaltet werden. Andere Schaltungen, ebenfalls mit direkter Injektion der Steuerströme, wurden im Artikel »A Simple High Performance Current-Switched Josephson Gate« beschrieben, der in der Ausgabe vom 15. Mai 1979 der Applied Physics Letters erschienen ist.

Die Verwendung von über den zu steuernden Josephson-Elementen angeordneten Kontrolleitungen weist eine Reihe von Nachteilen auf: die Schaltungen erfordern eine relativ große Fläche, sie müssen gedämpft werden, um Resonanzen zu vermeiden, und sie verlangen magnetische Abschirmungen, da in der Grundplatte gefangene Flußquanten sonst zu fehlerhaften Schaltvorgängen führen können. Darüber hinaus können zwischen den Kontrolleitungen und der supraleitenden Schleife induktive Kopplungen auftreten, wodurch eine völlige Entkopplung zwischen Eingang und Ausgang der Schaltung nicht möglich ist. Letztere Probleme werden bei zunehmender Reduzierung der Schaltungsabmessungen immer kritischer.

Die in den angeführten Referenzen beschriebenen Anordnungen mit direkter Strominjektion weisen andere Nachteile auf: die Entkopplung von Eingang und Ausgang ist für manche Anwendungen nicht ausreichend und erfordert, z. B. bei der im letztgenannten Artikel beschriebenen Anordnung, eine separate Gatestromquelle für jedes Josephson-Element, um die Toleranzen der Ströme und Schaltungselemente nicht zu kritisch werden zu lassen.

Die vorliegende Erfindung bietet eine den heutigen Anforderungen entsprechende Ausführung einer Josephson-Schaltung, die gekennzeichnet ist durch die parallele Anordnung eines ersten Schaltungszweiges, der aus einem ersten Widerstand und einem mit diesem in Reihe geschalteten ersten Josephson-Element besteht, und eines zweiten Schaltungszweiges, der aus einem zweiten Josephson-Element besteht, durch eine an die Verbindungspurkte der Zweige angeschlossene, den Gatestrom liefernde Stromquelle, dadurch, daß der Schaltungseingang an den Verbindungspunkt von Widerstand und Josephson-Element des ersten Zweiges und der Ausgang an den Verbindungspunkt von Widerstand und Josephson-Element des zweiten Zweiges angeschlossen sind, und daß der erste Widerstand mit dem zweiten Josephson-Element und der zweite Widerstand mit dem ersten Josephson-Element verbunden ist.

Ferner wird eine Verwendung dieser Schaltung in logischen Schaltanordnungen aufgezeigt, wobei die Ausgänge von wenigstens zwei solcher Schaltungen mit den Eingängen wenigstens eines Interferometers verbunden sind, das seinerseits ein von der vorgesehenen logischen Verknüpfung und von den von den Schaltungen zugeführten Strömen abhängiges Ausgangssignal liefert.

Die durch die Erfindung erreichten Vorteile sind im wesentlichen darin zu sehen, daß durch die gewählte Strominjektionsmethode und die angegebene Schaltungsanordnung räumlich kleine, für sehr kurze Operationszeiten geeignete und hinsichtlich der Stromversorgung wenig aufwendige Schaltungen möglich sind und daß, darüber hinaus, eine wesentliche Verbesserung der Trennung bzw. Entkopplung von Ein- und Ausgang erzielt wird.

Im folgenden wird die Erfindung anhand von lediglich Ausführungsbeispiele darstellenden Zeichnungen näher erläutert. Es zeigt

Fig. 1 das Schaltbild einer erfindungsgemäßen Schaltung mit zwei Josephson-Elementen und direkter Stromkopplung,

Fig. 2 und 3 für die Schaltung nach Fig. 1 die Verteilung und den Fluß des Eingangsstromes $I_c$ in Abhängigkeit vom Zustand der Josephson-Elemente: Fig. 2 für den Fall, daß beide Josephson-Elemente sich im spannungslosen Zustand befinden, während Fig. 3 die Situation kennzeichnet, wenn eines der Josephson-Elemente (J2) in den Spannungszustand geschaltet wurde,

Fig. 4 eine graphische Darstellung des Schaltverhaltens der Schaltung nach Fig. 1 in Abhängigkeit von den Eingangs-($I_c$) und Gate-($I_g$) Strömen,

Fig. 5 eine schematische Darstellung des Aufbaus einer Schaltung nach Fig. 1,

Fig. 6 ein Schaltbild einer Schaltanordnung, in der die Schaltung nach Fig. 1 mit einer Verstärkerschaltung gekoppelt ist,

Fig. 7 ein Schaltbild einer logischen Schaltungsanordnung, in der zwei Schaltungen nach Fig. 1 zusammen mit einem nachgeschalteten Interferometer eine UND-Schaltung ergeben, und

Fig. 8 eine weitere logische Schaltungsanordnung, bei der vier Schaltungen nach Fig. 1 mit nachgeschalteten Interferometern zusammenarbeiten.

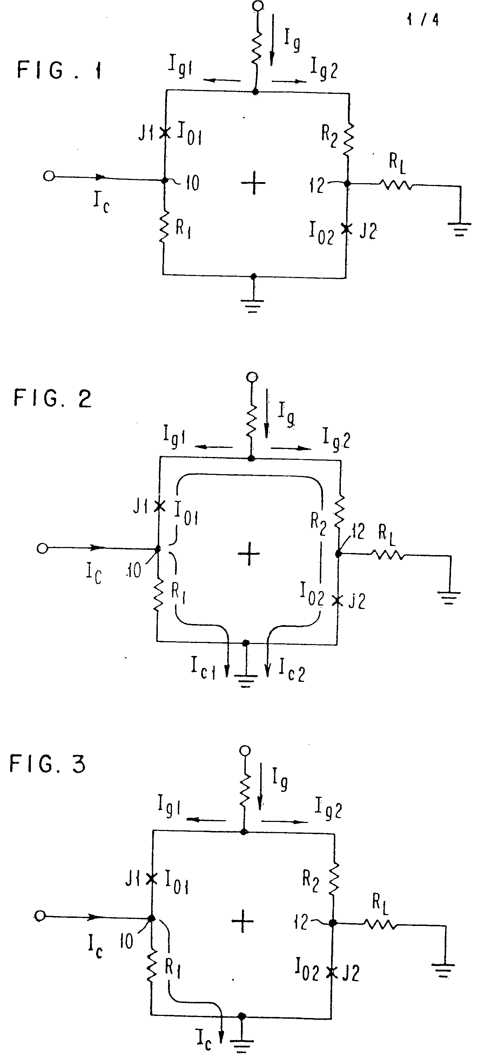

In Fig. 1 ist ein Ausführungsbeispiel einer erfindungsgemäßen Schaltung mit zwei Josephson-Elementen gezeigt, die im weiteren als Isolations- oder Trennschaltung bezeichnet werden wird. Die Josephson-Elemente sind mit J1 und J2 bezeichnet, zwei mit diesen in Reihe geschaltete Widerstände mit $R_1$ und $R_2$. Die Schaltung besteht aus zwei parallel geschalteten Zweigen, von denen der erste aus dem Josephson-Element J1 und dem Widerstand $R_1$ besteht, während der zweite das Josephson-Element J2 und den Widerstand $R_2$ aufweist. Diese Schaltungsanordnung kann aus bekannten Materialien bestehen, beispielsweise aus solchen Bleilegierungen, wie sie von J. H. Greiner et al beschrieben wurden im Journal Vac. Sci. Technol. 11, 81 (1974).

Eine nicht gezeigte Quelle liefert einen Gatestrom $I_g$, der durch die Josephson-Elemente J1 und J2 fließt. Ein Eingangsstrom $I_c$ wird dem Verbindungspunkt 10 vom Josephson-Element J1 und Widerstand $R_1$ im ersten Zweig zugeführt, während der Schaltungsausgang mit dem Verbindungspunkt 12 vom Josephson-Element J2 und Widerstand $R_2$ verbunden ist. Ein Lastwiderstand $R_L$ ist an den Verbindungspunkt 12 angeschlossen.

Der Gatestrom $I_g$ teilt sich in zwei Zweigströme $I_{g1}$ und $I_{g2}$ auf. Wie weiter unten erläutert werden wird, wird der gesamte Strom $I_g$ auf den Lastwiderstand $R_L$ geschaltet, wenn beide Josephson-Elemente J1 und J2 sich im Spannungszustand befinden. Vom Strom $I_g$ fließt nichts in den Eingangskreis, in welchem der Kontrollstrom $I_c$ fließt.

Fig. 2 illustriert die Arbeitsweise der Trennschaltung nach Fig. 1 für den Fall, daß beide Josephson-Elemente J1 und J2 sich im spannungslosen Zustand befinden. Wie bekannt ist, können Josephson-Elemente zwischen einem spannungslosen Zustand und einem Spannungszustand umgeschaltet werden. In Fig. 2 ist die Stromverteilung der Ströme $I_{g1}$ und $I_{g2}$ für den Fall angegeben, in dem beide Josephson-Elemente sich im spannungslosen Zustand befinden. Die beiden Zweigströme sind den Widerstandswerten $R_1$ und $R_2$ umgekehrt proportional.

Fig. 2 zeigt auch die Aufteilung des Eingangskontrollstromes $I_c$ in die beiden Zweigströme $I_{c1}$ und $I_{c2}$. Aus der Zeichnung ist ersichtlich, daß die Ströme $I_{c2}$ und $I_{g2}$ in der gleichen Richtung durch das Josephson-Element J2 fließen, während die Ströme $I_{c2}$ und $I_{g1}$ das Josephson-Element J1 in entgegengesetzter Richtung durchfließen. Wie bereits erwähnt, fließt ferner der Gatestrom $I_g$, in die Zweigströme $I_{g1}$ und $I_{g2}$ aufgeteilt, durch beide Josephson-Elemente, wenn sich diese in ihrem spannungslosen Zustand befinden.

Die Arbeitscharakteristik der Schaltung nach Fig. 1 ist derart, daß mit der Zuführung des Eingangsstromes $I_c$ dessen durch das Josephson-Element J2 fließende Anteil $I_{c2}$ dieses Element in den Spannungszustand schaltet. Dies bewirkt, daß der größte Anteil des Gatestroms $I_g$

durch das Josephson-Element J1 fließt. Nur ein sehr kleiner Anteil des Gatestroms fließt durch den Widerstand $R_2$ und durch den Lastwiderstand $R_L$ ab. Element J1 wiederum hat eine Schwellwert-Charakteristik derart, daß dieses Element durch den erhöhten Gatestromanteil ebenfalls in den Spannungszustand schaltet. Nachdem dies erfolgt ist, fließt der gesamte Gatestrom durch den Widerstand $R_2$ in den Lastwiderstand $R_L$.

Fig. 3 zeigt die Situation nachdem Josephson-Element J2 in den Spannungszustand umgeschaltet wurde. Der Zweigstrom $I_{g1}$ ist jetzt wesentlich größer als der Strom $I_{g2}$, welches bewirkt, daß das Josephson-Element J1 ebenfalls in den Spannungszustand umschaltet. Da Element J2 im Spannungszustand ist, und da der Widerstand $R_1$ erheblich geringer ist als der Widerstand $R_L$, fließt der größte Anteil des Eingangskontrollstroms $I_c$ durch den Widerstand $R_1$ an Masse wie in Fig. 3 gezeigt.

Nachdem Element J1 in den Spannungszustand umgeschaltet ist, fließt somit der gesamte Gatestrom $I_g$ durch $R_2$ und $R_L$. Vom Gatestrom fließt nichts zurück in den Eingangskreis, in den der Strom $I_c$ injiziert wird, da beide Element J1 und J2 umgeschaltet sind. Letztere können in den spannungslosen Zustand zurückgeschaltet werden, indem der Gatestrom $I_g$ reduziert wird. Diese Steuerung kann beispielsweise durch Anlegen eines Wechselstroms erfolgen.

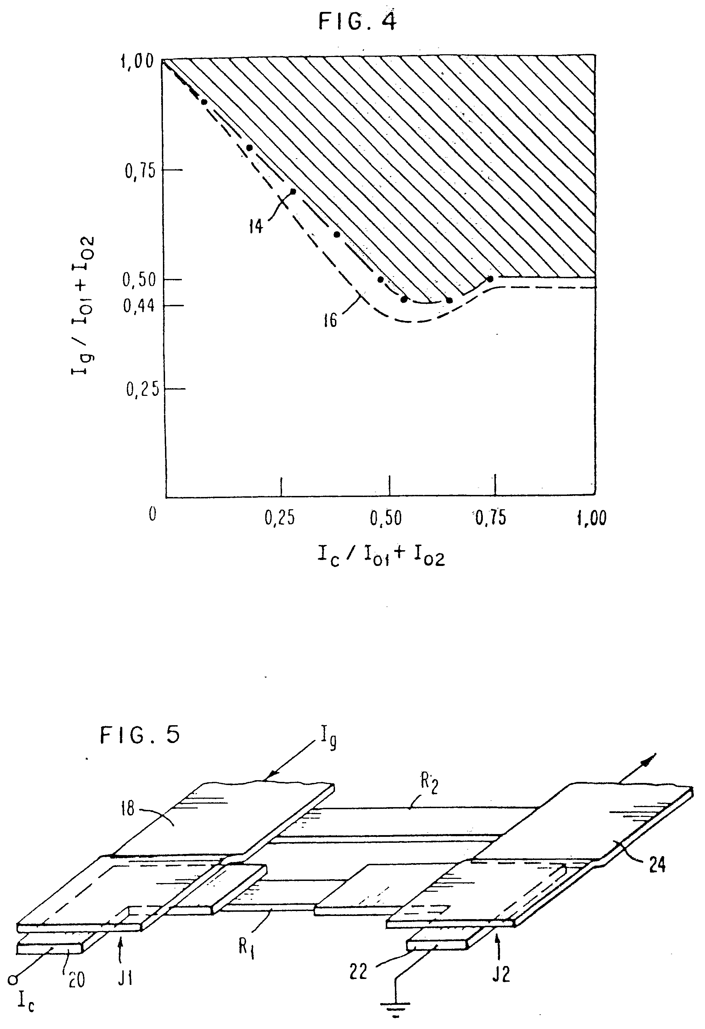

Fig. 4 zeigt die Verstärkungskurve der Schaltung nach Fig. 1. Als Funktion des Eingangskontrollstromes $I_c$ gibt die Kurve jeweils den maximalen Gatestrom $I_g$ an, bei dem die Josephson-Elemente der Trennschaltung noch im spannungslosen Zustand verbleiben. Der maximale Gatestrom sowie der Kontrollstrom sind normalisiert bezogen auf die Summe des maximalen Gatestroms, der durch die Josephson-Elemente J1 und J2 fließen kann, wenn kein Kontrollstrom $I_c$ zugeführt wird. $I_{01}$ ist der maximale Gatestrom, der durch das Element J1 fließen kann ohne dieses in den Spannungszustand zu schalten, während $I_{02}$ der entsprechende Strom für das Element J2 ist.

Fig. 4 zeigt, daß die Josephson-Elemente der Schaltung nach Fig. 1 im spannungslosen Zustand verbleiben für alle durch die jeweiligen Ströme $I_g$ und $I_c$ gegebenen Operationspunkte, die unterhalb der schraffierten Fläche liegen. Fällt der Arbeitspunkt in den schraffierten Bereich, so befindet sich die Schaltung im Spannungszustand. Die obere Kurve 14 wurde ermittelt durch Anlegen eines Eingangssignals $I_c$ mit sehr flacher Anstiegsflanke, während die untere Kurve 16 für Eingangsströme $I_c$ mit kurzer Anstiegszeit, z. B. 100 Picosekunden, Gültigkeit hat.

Um ein optimales Schaltverhalten und vor allem eine maximale Trennung von Eingang und Ausgang zu erzielen, werden an die Schaltungselemente und Parameter die folgenden Bedingungen gestellt:

1. $I_{01}R_1 = I_{02}R_2$,

2. $\dfrac{R_1}{R_1 + R_2} I_c + I_{g2} > I_{02}$

3. $\dfrac{R_2 + R_L}{R_1 + R_2 + R_L} I_g - \dfrac{R_1}{R_1 + R_2 + R_L} I_c > I_{01}$.

Einhalten der Bedingung 1 bewirkt, daß der maximale Gatestrom $I_g$ gleich der Summe der kritischen Ströme $I_{01}$ und $I_{02}$ ist. Die zweite Bedingung stellt sicher, daß $I_{g2}$ und $I_{c2}$ ausreichend sind, um das Element J2 umzuschalten. Dieses ist also die Bedingung dafür, daß das Element J2 beim Anlegen des Kontrollstroms $I_c$ mit Sicherheit in den Spannungszustand schaltet. Die oben angegebene Bedingung 3 stellt sicher, daß der Anteil des Gatezweigstroms $I_{g1}$, der nach Umschalten von J2 durch J1 fließt, ausreichend ist, um das Element J1 in den Spannungszustand zu bringen. Werden die genannten drei Bedingungen eingehalten, so ist ein sicheres Umschalten für beide Josephson-Elemente gewährleistet, wenn der Eingangsstrom $I_c$ angelegt wird.

Wie bereits erwähnt wurde, ist nur eine einzige Gatestromquelle erforderlich, obwohl in der Schaltung zwei Josephson-Elemente Verwendung finden. Da ein Gatestrom $I_{g1}$ auch dann durch das Element J1 fließt, wenn J2 sich im spannungslosen Zustand befindet, und da $I_{c2}$ in entgegengesetzter Richtung durch J1 fließt, kann ein großer Eingangsstrom $I_c$ verwendet werden, um ein sicheres Umschalten von J2 zu erreichen.

In der Schaltung nach Fig. 1 ist der Ausgang mit dem Punkt 12, d. h. dem Verbindungspunkt zwischen $R_2$ und J2, verbunden. Dies bedeutet, daß in den Lastwiderstand $R_L$ kein Gatestrom abfließt solange Element J1 und J2 sich im spannungslosen Zustand befinden.

Fig. 5 zeigt, wie die Schaltung nach Fig. 1 praktisch ausgelegt werden kann. In dieser Zeichnung besteht das Josephson-Element J1 aus einer supraleitenden Gegenelektrode 18 und einer supraleitenden Basiselektrode 20. Eine Tunnelbarriere ist zwischen diesen Elektroden 18 und 20 angeordnet, die hinreichend dünn ist, um einen Josephson-Tunnelstrom zu ermöglichen.

Der Widerstand $R_1$ verbindet die Basiselektrode 20 mit der Basiselektrode 22 des Josephson-Elements J2. Zwischen dieser Basiselektrode 22 und der Gegenelektrode 24 des Elements J2 befindet sich wiederum eine dünne Tunnelschicht. Der Widerstand $R_2$ verbindet die Elektroden 18 und 24. Der Gatestrom $I_g$ wird der supraleitenden Elektrode 18 zugeführt, während der Eingangsstrom $I_c$ an die supraleitende Elektrode 20 angelegt wird. Das Ausgangssignal der Schaltung wird von der supraleitenden Elektrode 24 abgenommen.

Die Anordnung nach Fig. 5 kann in bekannter Weise hergestellt werden, indem nacheinander die verschiedenen supraleitenden Materialien, wie z. B. Bleilegierungen und/oder Niobium, aufgebracht werden. Der bereits erwähnte Greiner-et-al-Artikel beschreibt einen geeigneten Prozeß für die Herstellung solcher Anordnungen.

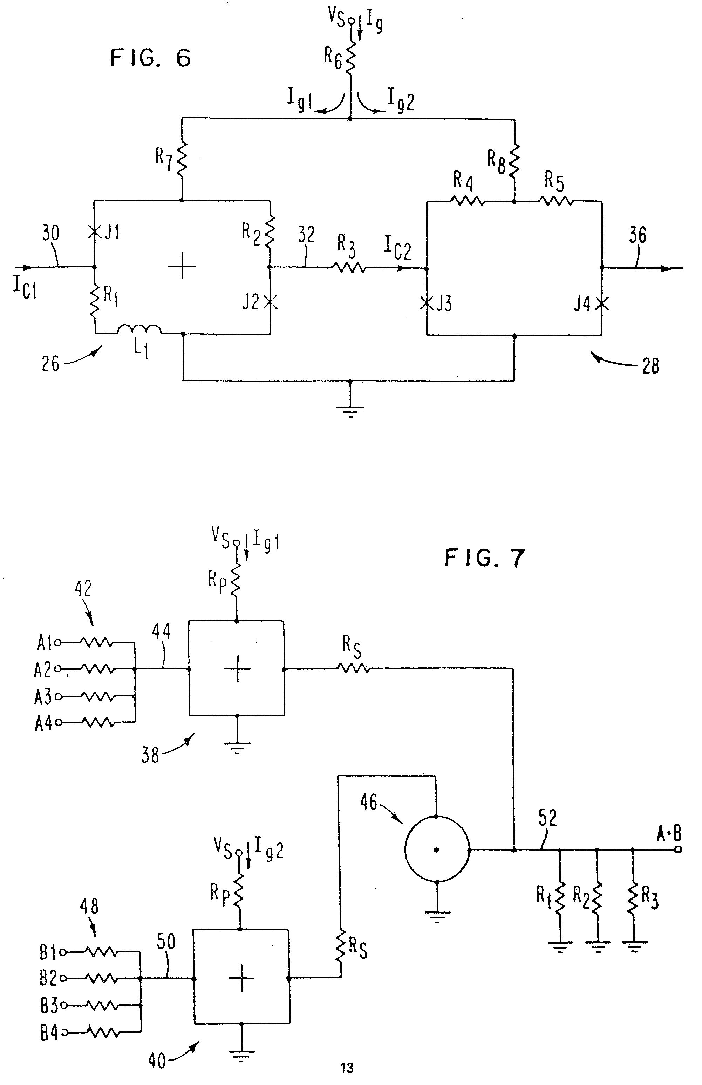

Die in Fig. 6 gezeigte Schaltungsanordnung weist zwei Stufen auf: zunächst eine Trennschaltung 26, wie sie vorstehend beschrieben wurde, und ferner eine Verstärkerstufe 28, die ihrerseits wiederum aus einer Trennschaltung bestehen kann. Diese Stufen werden von einem gemeinsamen Gatestrom $I_g$ durchflossen, der sich in die Zweige $I_{g1}$ und $I_{g2}$ aufteilt. Der Ausgangsstrom der Stufe 26 bildet den Eingangsstrom $I_{c2}$ der zweiten Stufe 28.

Die Trennstufe 26 besteht wiederum aus den Josephson-Elementen J1 und J2 sowie den Widerständen $R_1$ und $R_2$. Der Eingangsstrom $I_{c1}$ wird über die Leitung 30 zugeführt, während der Ausgangsstrom auf die Übertragungsleitung 32 gegeben wird, wenn beide Elemente J1 und J2 sich im Spannungszustand befinden. Der Widerstand $R_3$ begrenzt den in der Leitung 32 fließenden Strom. Die Induktivität $L_1$ in der Schaltung 26 dient dazu, daß Umschalten der Elemente J1 und J2 zu beschleunigen.

Die Stufe 28 besteht aus zwei Josephson-Elementen J3 und J4 sowie aus den Widerständen $R_4$ und $R_5$. Die gesamte Anordnung weist ferner einen Begrenzungswiderstand $R_6$ auf, der an die nicht gezeigte Gatestromquelle angeschlossen ist, sowie die Widerstände $R_7$ und $R_8$, die in den Gatestromzuführungsleitungen zu den Stufen 26 und 28 angeordnet sind.

Die Trennschaltung 26 arbeitet identisch der, die anhand der Fig. 1 beschrieben wurde. Sowie ein Strom $I_{c1}$ angelegt wird, schaltet das Element J2 in seinen Spannungszustand und der größte Anteil des Gatestroms fließt dann durch Element J1, welches ebenfalls in den Spannungszustand umschaltet. Sobald beide Elemente J1 und J2 geschaltet sind, wird der Strom $I_{g1}$ der Ausgangsübertragungsleitung 32 und damit der Stufe 28 zugeführt.

Die Arbeitsweise der Verstärkerstufe 28 ist ähnlich der Trennschaltung 26. Wenn der Strom $I_{c2}$ angelegt wird, schaltet das Josephson-Element J3 in den Spannungszustand um und bewirkt damit einen erhöhten Gatestrom durch das Element J4. Dieser erhöhte Gatestrom zusammen mit $I_{c2}$ schaltet J4 in den Spannungszustand um. Damit wird der Strom $I_g = I_{g1} + I_{g2}$ auf die Ausgangsleitung 36 gegeben.

In der Schaltung nach Fig. 6 ist der Ausgangsstrom auf der Leitung 36 der Summe der Ströme $I_{g1}$ und $I_{g2}$ proportional. Für einen gegebenen Eingangsstrom $I_{c1}$ kann ein höherer Ausgangsstrom erreicht werden. Eine Mehrzahl von Stufen kann verwendet werden, um die Stromverstärkung der Gesamtschaltung noch weiter zu erhöhen.

In Fig. 6 wurde eine Verstärkerstufe gezeigt, die sich von der in Fig. 1 gezeigten Trennschaltung unterscheidet. Eine solche Trennschaltung könnte jedoch auch als Verstärkerstufe dienen.

Typische Werte der Schaltungsparameter der Anordnung nach Fig. 6 sind nachstehend aufgeführt:

| | | |
|---|---|---|
| $R_1$ | = | 1 Ohm |
| $R_2$ | = | 0,5 Ohm |
| $R_3$ | = | 8 Ohm |
| $R_4$ | = | 2,5 Ohm |
| $R_5$ | = | 1,7 Ohm |
| $R_6$ | = | 34 Ohm |
| $R_7$ | = | 20 Ohm |
| $R_8$ | = | 17 Ohm |
| $L_1$ | = | 25 pH |
| $I_{01}$ (J1) | = | 30 µA |
| $I_{02}$ (J2) | = | 60 µA |
| $I_{03}$ (J3) | = | 45 µA |
| $I_{04}$ (J4) | = | 60 µA |
| $V_s$ | = | 6 mV |

Fig. 7 zeigt eine UND-Schaltung mit zwei Eingängen, die beide mit einem Eingangssignal belegt sein müssen, um ein Ausgangssignal zu liefern. Zwei Trennschaltungen 38 und 40 werden verwendet, die der Schaltung nach Fig. 1 entsprechen können. Die mit 38 bzw. 40 bezeichneten Blöcke können jedoch auch jeweils aus einer Mehrstufenschaltung gemäß Fig. 6 bestehen. Die Eingänge der Schaltungen 38 und 40 sind jeweils mit ODER-Netzwerken verbunden.

Das ODER-Netzwerk 42 ist über die Eingangsleitung 44 mit der Schaltung 38 verbunden. Damit kann eine Mehrzahl von Eingangsströmen über die Leitungen A1, A2, A3 und A4 über die Leitung 44 der Schaltung 38 zugeführt werden, deren Josephson-Elemente in den Spannungszustand umschalten. Die Trennschaltung 38 wirkt zusammen mit den Eingängen A1 bis A4 somit als ODER-Schaltung. Im gezeigten Beispiel genügt bereits ein Eingangssignal auf einem der Eingänge A1 bis A4, um die Schaltung 38 zu schalten. Eine nicht gezeigte Stromquelle liefert den Gatestrom $I_{g1}$, der durch den Widerstand $R_p$ der Trennschaltung 38 zugeführt wird. Beide Josephson-Elemente dieser Schaltung schalten in den Spannungszustand um, und der Strom $I_{g1}$ wird durch den Widerstand $R_S$ dem nachgeschalteten Interferometer 46 zugeführt. Dieses Interferometer 46 besteht ebenfalls aus Josephson-Elementen und kann beispielsweise dem entsprechen, das im US-Patent 4 117 354, Fig. 4A, beschrieben wird.

Das Netzwerk 48 ist über die Eingangsleitung 50 mit der Trennschaltung 40 verbunden. Eine nicht gezeigte Stromquelle liefert den Gatestrom $I_{g2}$ für die Schaltung 40. Ein Eingangssignal auf einen der Eingänge B1 bis B4 wird die Josephson-Elemente der Schaltung 40 wiederum in den Spannungszustand umschalten, wodurch der Gatestrom $I_{g2}$ über den mit dem Ausgang der Schaltung verbundenen Widerstand $R_s$ einem weiteren Eingang des Interferometers 46 zugeführt wird. Beim gleichzeitigen Eintreffen von Ausgangsströmen der Schaltungen 38 und 40 schaltet das Interferometer 46 um und liefert ein Ausgangssignal auf die Leitung 52. Dieses Ausgangssignal A.B entspricht der logischen UND-Verknüpfung der Ausgangssignale der Schaltungen 38 und 40. Dieses Signal tritt also auf, wenn wenigstens einem der Eingänge A1 bis A4 und einem der Eingänge B1 bis B4 Signale zugeführt werden. Die Widerstände R1, R2 und R3 ermöglichen in bekannter Art ein Ausfächern des Ausgangssignals des Interferometers 46.

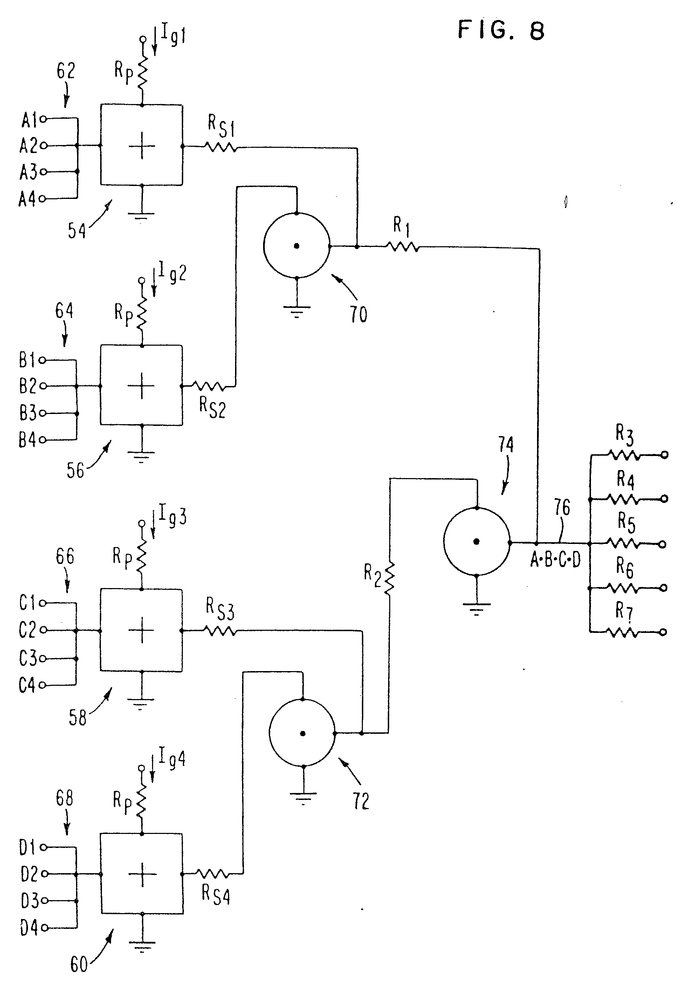

Fig. 8 zeigt eine direkt gekoppelte ODER-UND-Schaltung mit $4 \times 4$ Eingängen, die im Prinzip der UND-Schaltung der Fig. 7 ähnlich ist. Die Anordnung weist vier Trennschaltungen 54, 56, 58 und 60 auf, die denen entsprechen, die in Fig. 1 gezeigt und auch in der Schaltung nach Fig. 6 verwendet werden. Die Eingänge dieser Trennschaltungen sind jeweils mit einem ODER-Netzwerk 62, 64, 55 bzw. 68 verbunden. Diese können Eingangssignale über die Eingänge A1 bis A4, B1 bis B4, C1 bis C4, bzw. D1 bis D4 empfangen.

Nicht gezeigte Stromquellen liefern Gateströme $I_{g1}$, $I_{g2}$, $I_{g3}$ und $I_{g4}$ für die Trennschaltungen 54, 56, 58 und 60. Deren Ausgänge sind über Widerstände $R_{S1}$, $R_{S2}$, $R_{S3}$ und $R_{S4}$ in der in Fig. 8 dargestellten Weise mit den Eingängen der Interferometer 70 und 72 verbunden. Diese Interferometer können wieder denen entsprechen, die in Fig. 4A des bereits erwähnten US-Patents 4 117 354 gezeigt sind.

Widerstände $R_1$ und $R_2$ sind in den Ausgangsübertragungsleitungen angeordnet, die von den Interferometern 70 und 72 zum Interferometer 74 führen. Letzteres kann auch wiederum dem im erwähnten US-Patent beschriebenen entsprechen, es unterscheidet sich von den Interferometern 70 und 72 nur dadurch, daß der kritische Stromwert seiner Josephson-Elemente größer ist als der der Josephson-Elemente der Interferometer 70 und 72, um größere, durch die Widerstände $R_1$ und $R_2$ empfangener Injektionsströme aufnehmen zu können. Die Widerstände $R_3$ bis $R_7$ dienen wiederum der parallelen Ausfächerung der vom Interferometer 74 auf die Ausgangsübertragungsleitung 76 gegebenen Ausgangssignale.

Das auf die Ausgangsleitung 76 gegebenen Signal entspricht der logischen Verknüpfung A.B.C.D. Voraussetzung für dieses Signal ist, daß auf wenigstens jeweils einer der Eingänge A1 bis A4, B1 bis B4, C1 bis C4 und D1 bis D4 ein Eingangssignal gegeben wird. Anders ausgedückt, müssen alle Trennschaltungen 54, 56, 58 und 60 in den Spannungszustand umgeschaltet sein und damit die Gateströme $I_{g1}$ bis $I_{g4}$ über die Lastwiderstände $R_{S1}$ bis $R_{S4}$ an die Eingänge der Interferometer 70 und 72 leiten. Diese Interferometer schalten und bewirken ihrerseits, daß auch das Interferometer 74 umschaltet und ein Ausgangssignal auf die Leitung 76 gibt.

Für eine ODER-UND-Schaltung gemäß Fig. 8 ergeben sich folgende typische Betriebswerte: Die Signalverzögerung beträgt 48 Picosekunden, während die Zykluszeit, die dem minimalen zeitlichen Abstand zweier aufeinanderfolgender Eingangssignale entspricht, 110 Picosekunden betragen kann ohne daß sich die aufeinanderfolgenden Signale störend beeinflussen. Dies bedeutet, daß im Zeitraum von 110 Picosekunden die Polarität der die Gateströme liefernden Stromquelle $V_s$ umgekehrt werden kann, wodurch die Josephson-Elemente in den spannungslosen Zustand zurückgeschaltet werden. Diese Betriebswerte wurden beispielsweise erreicht mit einer Anordnung, in der die Schaltungen 54, 56, 58 und 60 aus Mehrstufenschaltungen gemäß Fig. 6 bestanden, deren Schaltungselemente die im Zusammenhang mit der Beschreibung der Fig. 6 angegebenen Werte aufwiesen. Die weiteren, dort noch nicht angegebenen Widerstandswerte betrugen

$R_{S1} = R_{S2} = R_{S3} = R_{S4} = 4$ Ohm, und

$R_1 = R_2 = 2,5$ Ohm.

Anhand der Zeichnungen wurde die erfindungsgemäße Josephson-Schaltung beschrieben, die beispielsweise als Trennschaltung dienen kann und welcher große Eingangsströme zugeführt werden können, um schnelle und verläßliche Schaltvorgänge zu erreichen. Der Eingangsstrom fließt durch beide Josephson-Elemente der Schaltung, solange diese sich im spannungslosen Zustand befinden. Dadurch ergeben sich verbesserte Schaltungseigenschaften, ohne daß zusätzliche Gatestromquellen erforderlich werden. Die Schaltung ist besonders geeignet für die Verwendung in logischen Verknüpfungsschaltungen.

In der Schaltung sind die Josephson-Elemente durch Widerstände voneinander getrennt. Sie beruht auf dem Prinzip der direkten Strominjektion, wobei es wichtig ist, daß dieser Strom dem Verbindungspunkt zwischen einem Widerstand und einem Josephson-Element, die in Reihe geschaltet sind, zugeführt wird, und daß der Ausgang mit dem Verbindungspunkt der Elemente, Widerstand und Josephson, der zweiten Reihenschaltung verbunden ist. Unter diesen Voraussetzungen werden eine gute Isolation zwischen Eingang und Ausgang erreicht sowie weite Toleranzgrenzen der verwendeten Elemente ohne daß individuelle Gatestromquellen für die Josephson-Elemente erforderlich sind. Ferner ist der Ausgangsstrom praktisch gleich 0 solange sich die Josephson-Elemente der Schaltung im spannungslosen Zustand befinden.

Wenn die Schaltung gemäß Fig. 1 mit mehreren Eingangsleitungen verbunden ist, arbeitet sie als ODER-Schaltung. Wie dem Fachmann bekannt ist, können die Widerstände $R_1$ und $R_2$ auch durch Induktivitäten ersetzt werden, ohne daß sich das Schaltverhalten grundsätzlich ändert. Die Verwendung von Induktivitäten anstelle von Widerständen ist oft jedoch von Nachteil, da Resonanzen auftreten und die mit der Schaltung erzielbare Verstärkung reduziert wird. Die Verwendung von Induktivitäten kann jedoch bei Anwendungen in Speicherzellen von Vorteil sein, wenn sowohl Schalt- als auch Speicherfunktionen auszuüben sind. Ebenso bei anderen Anwendungen, bei denen spezielle Schaltkreischarakteristiken gewünscht werden.

Für den Fachmann wird es darüber hinaus klar sein, daß die verschiedensten, den Josephson-Effekt ausnutzenden Schaltungselemente verwendet werden können, und daß die Verwendung der erfindungsgemäßen Schaltung nicht auf die in der vorliegenden Beschreibung angegebenen UND- bzw. ODER-Schaltungen beschränkt ist.

## Patentansprüche

1. Injektionsstrom-gesteuerte Schaltung mit Josephson-Elementen, gekennzeichnet durch die parallele Anordnung eines ersten Schaltungszweiges, der aus einem ersten Widerstand ($R_1$) und einem mit diesem in Reihe geschalteten ersten Josephson-Element (J1) besteht, und eines zweiten Schaltungszweiges, der aus einem zweiten Widerstand ($R_2$) und einem mit diesem in Reihe geschalteten zweiten Josephson-Element (J2) besteht, durch eine an die Verbindungspunkte der Zweige angeschlossene, den Gatestrom ($I_g$) liefernde Stromquelle, dadurch, daß der Schaltungseingang an den Verbindungspunkt (10) von Widerstand ($R_1$) und Josephson-Element (J1) des ersten Zweiges und der Ausgang an den Verbindungspunkt (12) von Widerstand ($R_2$) und Josephson-Element (J2) des zweiten Zweiges angeschlossen sind, und daß der erste Widerstand ($R_1$) mit dem zweiten Josephson-Element (J2) und der zweite Widerstand ($R_2$) mit dem ersten Josephson-Element (J1) verbunden ist.

2. Schaltung nach Anspruch 1, dadurch gekennzeichnet, daß zwischen den charakteristischen Größen der Schaltungselemente und den der Schaltung zugeführten Eingangs- ($I_c$) und Gateströmen ($I_g$) folgende Beziehungen bestehen

1.    $I_{01} R_1 = I_{02} R_2$,

2.    $\dfrac{R_1}{R_1 + R_2} I_c + I_{g2} > I_{02}$,

3.    $\dfrac{R_2 + R_L}{R_1 + R_2 + R_L} I_g - \dfrac{R_1}{R_1 + R_2 + R_L} I_c > I_{01}$.

wobei die Widerstände und die maximalen Josephson-Ströme der Josephson-Elemente mit $R_1$ und $R_2$ bzw. mit $I_{01}$ und $I_{02}$ bezeichnet sind, der durch den zweiten Zweig fließende Gatestrom mit $I_{g2}$ und der an den Ausgang angeschlossene Lastwiderstand mit $R_L$.

3. Schaltung nach Anspruch 1, dadurch gekennzeichnet, daß wenigstens in einem der Schaltungszweige eine Induktivität ($L_1$) vorgesehen ist.

4. Schaltung nach Anspruch 1, dadurch gekennzeichnet, daß an den Schaltungseingang eine Mehrzahl von Eingangsleitungen angeschlossen ist.

5. Verwendung der Schaltung nach Anspruch 1 in logischen Schaltungsanordnungen, dadurch gekennzeichnet, daß die Ausgänge von wenigstens zwei Schaltungen (38, 40) nach Anspruch 1 mit den Eingängen wenigstens eines Interferometers (46) verbunden sind, das seinerseits ein von der vorgesehenen logischen Verknüpfung und von den ihm zugeführten Strömen abhängiges Ausgangssignal liefert.

6. Verwendung der Schaltung nach Anspruch 5, dadurch gekennzeichnet, daß eine Verstärkerstufe (28) zwischen die Schaltung (26) und den Eingang des Interferometers (46) geschaltet ist.

7. Verwendung der Schaltung nach Anspruch 6, dadurch gekennzeichnet, daß als Verstärkerstufe eine Schaltung nach Anspruch 1 vorgesehen ist.

## Claims

1. Injection-current controlled circuit equipped with Josephson elements, characterized by a parallel arrangement of a first circuit branch comprising a series connection of a first resistor ($R_1$) and a first Josephson element (J1) and a second circuit branch comprising a series connection of a second resistor ($R_2$) and a second Josephson element (J2), by a current source connected to the connecting points of the branches and providing the gate current ($I_g$), and in that the circuit input is coupled to the connecting point (10) between the resistor ($R_1$) and the Josephson element (J1) of the first branch, and that the circuit output is coupled to the connecting point (12) between the resistor ($R_2$) and the Josephson element (J2) of the second branch, and that the first resistor ($R_1$) is connected with the second Josephson element (J2) and the second resistor ($R_2$) with the first Josephson element (J1).

2. A circuit as claimed in claim 1, characterized in that the following relations exist between the characteristic values of the circuit elements and the input-($I_c$) and gate-current ($I_g$) applied to the circuit

1.   $I_{01}R_1 = I_{02}R_2$,

2.   $\dfrac{R_1}{R_1+R_2}\, I_c + I_{g2} > I_{02}$,

3.   $\dfrac{R_2+R_L}{R_1+R_2+R_L}\, I_g - \dfrac{R_1}{R_1+R_2+R_L}\, I_c > I_{01}$.

wherein the resistors and the maximum Josephson currents of the Josephson elements are designated $R_1$, $R_2$, and $I_{01}$, $I_{02}$, respectively, the gate current through the second branch $I_{g2}$, and the load resistor connected to the circuit output

$R_L$.

3. A circuit as claimed in claim 1, characterized in that an inductance ($L_1$) is provided in at least one of the circuit branches.

4. A circuit as claimed in claim 1, characterized in that a plurality of input lines is connected to the circuit input.

5. Application of the circuit according to claim 1 in logical circuitries, characterized in that the outputs of at least two of said circuits (38, 40) are connected with the inputs of at least one interferometer (46) which, in turn, provides an output signal that depends on the intended logic function to be performed and on the applied currents.

6. Application of the circuit as claimed in claim 5, characterized in that an amplifier stage (28) is connected between the circuit (26) and the input of the interferometer (46).

7. Application of the circuit as claimed in claim 6, characterized in that an amplifier stage consists of a circuit as claimed in claim 1.

## Revendications

1. Circuit à éléments de Josephson commandé par courant d'injection, caractérisé par l'agencement en parallèle d'une première branche de circuit composée par une première résistance ($R_1$) en série avec un premier élément de Josephson (J1), et d'une deuxième branche de circuit composée par une deuxième résistance ($R_2$) en série avec un deuxième élément de Josephson (J2), par le branchement aux points de jonction des deux branches d'une source de courant fournissant le courant de grille ($I_g$), et par le fait que l'entrée du circuit est raccordée au point de jonction (10) de la résistance ($R_1$) et de l'élément de Josephson (J1) de la première branche, et que la sortie du circuit est raccordée au point de jonction (12) de la résistance ($R_2$) et de l'élément de Josephson (12) de la deuxième branche, et par le fait que la première résistance (RHIY) est reliée au deuxième élément de Josephson (J2), ainsi que la seconde résistance ($R_2$) au premier élément de Josephson (J1).

2. Circuit selon la revendication 1, caractérisé par l'existence des relations ci-dessous entre les grandeurs caractéristiques des composants du circuit et les courants d'entrée ($I_c$) et de grille ($I_g$) alimentant le circuit:

1.   $I_{01}R_1 = I_{02}R_2$,

2.   $\dfrac{R_1}{R_1+R_2}\, I_c + I_{g2} > I_{02}$,

3.   $\dfrac{R_2+R_L}{R_1+R_2+R_L}\, I_g - \dfrac{R_1}{R_1+R_2+R_L}\, I_c > I_{01}$.

où les résistances sont désignées par $R_1$ et $R_2$, les courants maximum de Josephson des éléments

de Josephson par $I_{01}$ et $I_{02}$, le courant de grille circulant dans la deuxième branche par $I_{g2}$, et la résistance de charge raccordée à la sortie par $R_L$.

3. Circuit selon la revendication 1, caractérisé par la prévision, dans une des branches du circuit au moins, d'une inductance ($L_1$).

4. Circuit selon la revendication 1, caractérisé par le raccordement de plusieurs lignes d'entrée à l'entrée du circuit.

5. Utilisation du circuit conforme à la revendication 1 dans des agencements de circuits logiques, caractérisée par la liaison des sorties d'au moins deux desdits circuits (38, 40), conformes à la revendication 1, aux entrées d'un interféromètre (46) au moins, qui, pour sa part, fournit un signal de sortie dépendant de l'opération logique prévue et des courants appliqués.

6. Utilisation du circuit conforme à la revendication 5, caractérisée par le branchement d'un étage amplificateur (28) entre le circuit (26) et l'entrée de l'interféromètre (46).

7. Utilisation du circuit conforme à la revendication 6, caractérisée par le fait que l'étage amplificateur prévu est un circuit conforme à la revendication 1.

FIG . 1

FIG. 2

FIG. 3

FIG. 4

FIG. 5

FIG. 6

FIG. 7

FIG. 8